(19)

**Europäisches Patentamt**
**European Patent Office**
**Office européen des brevets**

(11)  **EP 2 942 802 A1**

(12)  # EUROPEAN PATENT APPLICATION

(43) Date of publication:
**11.11.2015 Bulletin 2015/46**

(51) Int Cl.:
**H01L 21/02** *(2006.01)*

(21) Application number: **14176156.9**

(22) Date of filing: **08.07.2014**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **07.05.2014 EP 14167360**

(71) Applicant: **NXP B.V.**
**5656 AG Eindhoven (NL)**

(72) Inventors:
• **Lander, Robert, J, P,**
**Redhil, Surrey RH1 1SH (GB)**
• **Delhougne, Romain**
**Redhill, Surrey RH1 1SH (GB)**

(74) Representative: **Crawford, Andrew**
**NXP SEMICONDUCTORS UK LTD**
**Intellectual Property & Licensing**
**Red Central**
**60 High Street**
**Redhill, Surrey RH1 1SH (GB)**

(54)  **Semiconductor substrates and methods of fabricating the same**

(57)    The invention relates to a semiconductor substrate having an outside surface and having a GaN-based layer and a Si layer. At least one of these layers is provided with a plurality of recesses that are arranged in a plane of the semiconductor substrate parallel to an outside surface of the substrate. The recesses are arranged to divert lateral propagation of a crack in the GaN-based layer into directions that are parallel to at least one of (1010), (1100), and (0110) planes of the GaN-based layer having a (0001) surface orientation so as to limit the lateral propagation of the crack. This invention also relates to semiconductor devices comprising the semiconductor substrate and methods of fabricating such a semiconductor substrate.

*Fig. 8*

EP 2 942 802 A1

**Description**

Field of the invention

This invention relates to semiconductor substrates, semiconductor devices comprising semiconductor substrates, and methods of fabricating semiconductor substrates. In particular, this invention relates to a semiconductor substrate comprising a gallium nitride-based (GaN-based) layer and a silicon (Si) layer.

Background of the invention

Over the past years, hetero-epitaxy of GaN-based layers on Si substrates has attracted a lot of attention as it enables substrates for wide-band gap semiconductor devices for high-voltage and high-temperature applications that can be fabricated at considerably lower cost than devices on bulk wide-band gap or sapphire substrates.

The large lattice mismatch between GaN-based epitaxial layers and Si substrates (17% for (0001) surface oriented GaN grown on (111) surface oriented Si) and the larger coefficient of thermal expansion for GaN-based layers in comparison to Si ($5.6 \times 10^{-6}$/K for GaN vs. $2.6 \times 10^{-6}$/K for Si) results in a high degree of tensile stress in the GaN-based layer following epitaxial growth and subsequent cool down from the growth temperatures to room temperature.

Although the degree of stress can be tuned with epitaxial growth parameters, residual stresses remain a major issue and surface cracks can result in significant yield loss or even wafer loss due to substrate breakage during device processing. This is also a major constraint in the design of GaN-based epitaxial layer stacks and choice of handle wafer thickness.

Summary of the invention

According to a first aspect of this invention, there is provided a semiconductor substrate having an outside surface and comprising a GaN-based layer and a Si layer, at least one of the GaN-based layer and the Si layer being provided with a plurality of recesses that are arranged in a plane parallel to said outside surface of the semiconductor substrate, wherein recesses of said plurality of recesses are arranged to divert lateral propagation of a crack in the GaN-based layer iinto directions that are parallel to at least one of (1010), (1100), and (0110) planes of the GaN-based layer.

In an embodiment, the recesses of the plurality of recesses comprise trenches having a depth and a length in a length direction, the length direction of the trenches being parallel to at least one of the (1010), (1100), and (0110) planes.

In an embodiment, the trenches provide a grid having a unit cell that comprises a first trench having a first length direction parallel to the (1010) plane, a second trench having a second length direction parallel to the (1100) plane, and a third trench having a third length direction parallel to the (0110) plane.

In an embodiment, the unit cell has a triangular shape.

In an embodiment, the grid is offset at an angle from a crystal orientation of the GaN-based layer, said crystal orientation being one of (0001) and (000-1).

In an embodiment, the length of the trenches and their positions with respect to each other are configured so as to limit the lateral propagation of the crack in the GaN-based layer in-between trenches having different orientations.

In an embodiment, the trenches are provided in a surface of the GaN-based layer facing away from the Si layer.

In an embodiment, the GaN-based layer has a thickness that exceeds the depth of the trenches.

In an embodiment, the trenches are provided in a surface of the Si layer facing towards the GaN-based layer.

In an embodiment, the GaN-based layer comprises at least one of a GaN, AlGaN, and InGaN layer having a (0001) surface orientation.

In an embodiment, the Si layer comprises one of a (111), (100), and (001) surface orientation.

According to a second aspect of this invention, there is provided a semiconductor device comprising a semiconductor substrate as defined above.

According to a third aspect of this invention, there is provided a method of fabricating a semiconductor substrate, the method comprising the steps of:

-    providing a GaN-based layer and a Si layer having an outside surface;
-    providing at least one of the GaN-based layer and the Si layer with a plurality of recesses that are arranged in a plane parallel to said outside surface of the semiconductor substrate, wherein recesses of said plurality of recesses are arranged to divert lateral propagation of a crack in the GaN-based layer into directions parallel to at least one of (1010), (1100), and (0110) planes of the GaN-based layer.

In an embodiment, the plurality of recesses are provided to the GaN-based layer by local etching of a surface of the GaN-based layer facing away from the Si layer.

EP 2 942 802 A1

In an embodiment, the plurality of recesses are provided by at least one of local etching and local oxidation of a surface of the Si layer facing towards the GaN-based layer.

Brief description of the drawings

Embodiments of the present invention will be described hereinafter, by way of example only, with reference to the accompanying drawings which are schematic in nature and therefore not necessarily drawn to scale. Furthermore, like reference signs in the drawings relate to like elements.

Figure 1 schematically shows a cross-section of a part of a known semiconductor substrate comprising a GaN layer and a Si handle or support layer under initial conditions prior to fracture of the semiconductor substrate at a flaw due to an amount of applied stress, $\sigma$.

Figure 2 shows an image of cracks in a GaN layer at an edge region of a known semiconductor substrate comprising a GaN-layer and a Si handle or support layer.

Figure 3 shows a schematic cross-section of a crack in a part of a known semiconductor substrate comprising a GaN-based layer 2 having a thickness ($h$) and a Si handle or support layer.

Figure 4 shows dimensionless strain energy release rate ($GE'/(\sigma_{GaN}^2 h)$) as a function of dimensionless depth ($a/h$), wherein a is a depth of the flaw and $h$ is the thickness of the GaN layer.

Figure 5a shows a schematic plan-view of a fracture or crack that is oriented in the (1010) plane of a (0001) surface oriented GaN-based layer that is hetero-epitaxially grown on a (111) surface oriented Si layer.

Figure 5b shows a schematic cross-section of the fracture along line A-A' of figure 5a.

Figure 5c shows a schematic cross-section of the fracture along line B-B' of figure 5a.

Figure 5d shows a schematic cross-section of the fracture along line C-C' of figure 5a.

Figure 6 shows a schematic cross-section of an embodiment of the semiconductor substrate, wherein a trench is provided in a surface of the GaN-based layer facing away from the Si layer.

Figure 7 shows a schematic cross-section of an embodiment of the semiconductor substrate, wherein a trench is provided in a surface of the Si layer facing towards the GaN-based layer.

Figure 8 shows a schematic top view of a layout of a grid having a triangular-shaped unit cell.

Figure 9a shows a schematic top view of the layout of the grid as shown in figure 8, wherein the crack shown in figure 9a has both a different initial fracture nucleation point than the crack shown in figure 8 and a different initial propagation direction.

Figure 9b shows a schematic top view of the layout of the grid as shown in figure 8, wherein the crack shown in figure 9b has both a different initial fracture nucleation point than the cracks shown in figures 8 and 9a, and a different initial propagation direction than these cracks.

Figure 10a shows a schematic top view of a simulated random walk of a crack in the GaN-based layer on a triangular lattice.

Figure 10b shows the results of a Monte Carlo simulation of the maximum lateral extent of the crack ($\Delta$max) following the random walk on the triangular lattice shown in figure 10a. The results shown in figure 10b are for various diversion or redirection probabilities (per step length, a).

Detailed description

Embodiments of the present invention are described in the following with reference to the accompanying drawings.

Catastrophic fracture of known semiconductor substrates comprising a GaN-based layer and a Si layer acting as a handle or support layer for these semiconductor substrates, depends strongly upon the depth of pre-existing cracks. The larger the depth to which cracks vertically propagate into the Si layer, the higher the probability of catastrophic fracture of these known semiconductor substrates. This probability is mainly due to complete breakage of the Si handle or support layer.

From a publication that can be assessed by following the hyperlink http://en.wikipedia.org/wiki/Fracture_mechanics#cite_note-1 and from a publication by A. A. Griffith, (1921), "The phenomena of rupture and flow in solids", Philosophical Transactions of the Royal Society of London, A 221: 163-198, it is known that fracture in brittle materials is limited by material properties, such as fracture toughness, and by the morphology of pre-existing flaws that are enlarged under stress to form the fracture. Larger applied stress and deeper flaws enhance the likelihood of fracture.

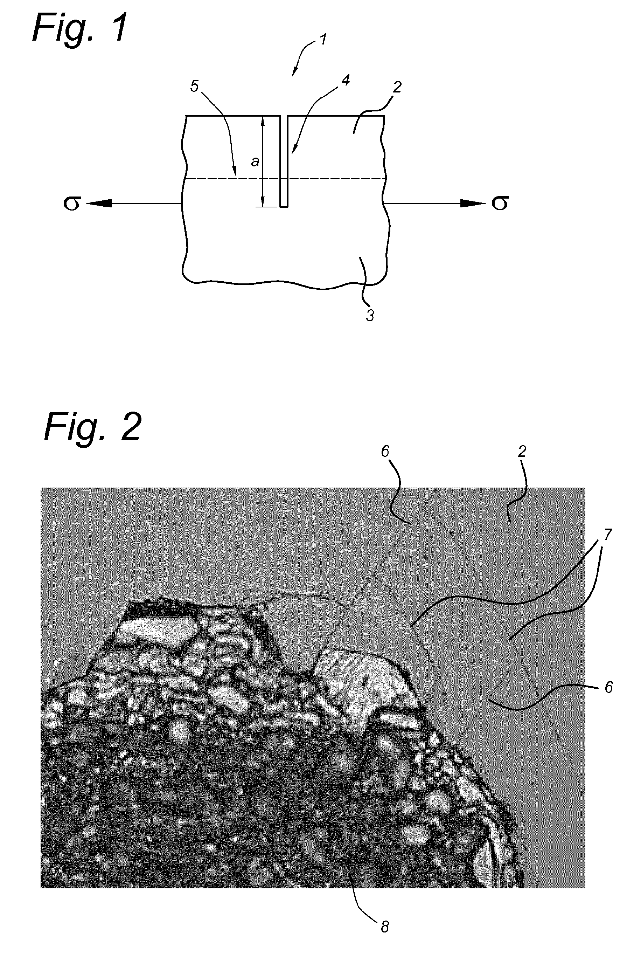

Figure 1 schematically shows a cross-section of a part of a known semiconductor substrate 1 comprising a GaN layer 2 and a Si handle or support layer 3 under initial conditions prior to fracture of the semiconductor substrate at a flaw 4 due to an amount of applied stress, $\sigma$. This stress may be applied during processing of the semiconductor

3

substrate. The location of an interface 5 between the GaN layer 2 and the Si layer 3 is shown for the case of a flaw 4 that is generated by tensile strain in the GaN layer that is hetero-epitaxially grown on the Si layer 3. In the situation shown in figure 1, the flaw 4 has a depth, a, from the surface of the GaN layer 2 facing away from the Si layer 3 and extends beyond the interface 5 into the Si layer 3. The skilled person will appreciate that larger amounts of applied stress, $\sigma$, and larger depths, a, of the flaw 4 enhance the likelihood of fracture of the semiconductor substrate 1.

For a tensile strained GaN epitaxial layer 2 on a (111) surface oriented Si layer 3, nucleation and growth of flaws 4 is mainly driven by tensile strain in the GaN layer 2. Generally this results in a dense network of cracks 6, 7 in the GaN layer 2 located close to an edge region 8 of the substrate 1. Figure 2 shows an image of such cracks 6, 7 in the GaN layer 2 at the edge region 8 of a known semiconductor substrate 1 comprising a GaN layer 2 and a Si handle or support layer 3. The high concentration of cracks 6, 7 at the edge 8 of the substrate 1 is due to the high density of crack nucleation centres where planar GaN epitaxy meets irregular GaN regions. The rough surface visible in the lower left corner of the image shown in figure 2 is due to poor epitaxial GaN growth on non-planar edges of the substrate 1.

Once a crack 6, 7 is formed in a surface of the GaN layer 2 that faces away from the Si layer 3, it will propagate vertically until it meets the unstrained Si layer 3, and laterally along the most favourable cleave planes of the GaN layer 2. From a publication by D.M. Follstaedt, J. Han, P. Provencio and J. G. Fleming, "Microstructure of GaN Grown on (111) Si by MOCVD", Proceedings of the Materials Research Society, Volume 537, 1998, it is known that for a (0001) surface oriented GaN-based layer on a (111) surface oriented Si layer the most favourable cleave plane is the (1010) plane or its equivalent.

A first crack 6 in the GaN layer 2 of the known substrate 1 shown in figure 2 will continue to propagate laterally until it reaches an unstressed GaN region or it intercepts a second crack 7. Examples of the latter situation are shown in figure 2.

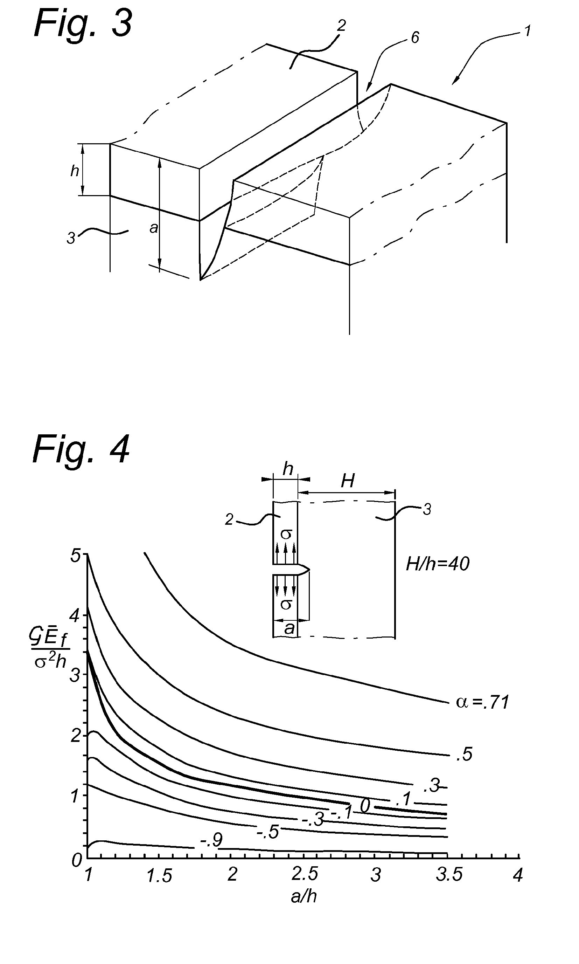

Figure 3 shows a schematic cross-section of a crack 6 in a part of a known semiconductor substrate 1 comprising a GaN-based layer 2 having a thickness (h) and a Si handle or support layer 3. From figure 3 it can be seen that the crack 6 extends laterally and vertically in both the GaN-based layer 2 and the Si layer 3. It can also be seen that the crack 6 has a depth a from the surface of the GaN layer 2 facing away from the Si layer 3 and that it extends beyond the interface 5 between the Si layer 3 and the GaN-based layer 2 into the Si layer 3. A driving force for the depth a to which the crack 6 penetrates into the Si layer 3 is further stress relief in the GaN layer 2. This driving force diminishes as the depth a of the crack 6 in the Si layer 3 increases.

The depth a to which the crack 6 penetrates into the Si layer 3 will greatly influence the resistance to fracture under an applied stress, $\sigma$. From the publication that can be assessed by following the hyperlink http://en.wikipedia.org/wiki/Fracture_mechanics#cite_note-1, from the publication by A. A. Griffith, (1921), "The phenomena of rupture and flow in solids", Philosophical Transactions of the Royal Society of London, A 221: 163-198, and from the publication by G. Irwin, (1957), "Analysis of stresses and strains near the end of a crack traversing a plate", Journal of Applied Mechanics 24, 361-364, it is known that the fracture criterion is defined as

$$K_I > K_{IC} \qquad\qquad \text{Eq. 1}$$

where $K_{IC}$ is the fracture toughness which is a material property having a value in a range of 0.7 - 1.3MPa√m for monocrystalline Si, and $K_I$ is the stress intensity factor that is given by

$$K_I = \sigma_{app}\sqrt{\pi a} \qquad\qquad \text{Eq. 2}$$

where $\sigma_{app}$ is the applied tensile stress, and a is the depth of the flaw 4 as shown in figure 1.

In a publication by J.W. Hutchinson and Z. Suo, "Mixed mode cracking in multilayers", Advances in Applied Mechanics, 29, 1992, it has been shown how to calculate the depth, a, to which a known semiconductor substrate 1 comprising a GaN layer 2 and a Si layer 3 is fractured due to the intrinsic stress in the GaN layer 2. Figure 4, which is taken from the latter publication, shows the dimensionless strain energy release rate ($GE'/(\sigma_{GaN}^2 h)$) as a function of the dimensionless depth (a/h), wherein a is the depth of the flaw 4 and h is the thickness of the GaN layer 2. In figure 4 the relevant curve for a substrate comprising a GaN layer on a Si layer is highlighted (Dundurs parameter $\alpha$~0). The energy release rate is related to the fracture toughness by

$$\frac{GE'}{\sigma_{GaN}^2 h} = \frac{K_{IC}^2}{\sigma_{GaN}^2 h} \qquad\qquad \text{Eq. 3}$$

Taking $K_{IC}$=1MPa$\sqrt{m}$ for a GaN layer having a thickness $h$ of 5$\mu$m with a uniform biaxial tensile stress $\sigma_{GaN}$ of 1GPa, gives a value for the dimensionless energy release rate $GE'/(\sigma_{GaN}^2 h)$ of approximately 0.3. Thus a crack will penetrate into the Si layer until $a/h\sim 10$, or to a depth a of 50$\mu$m.

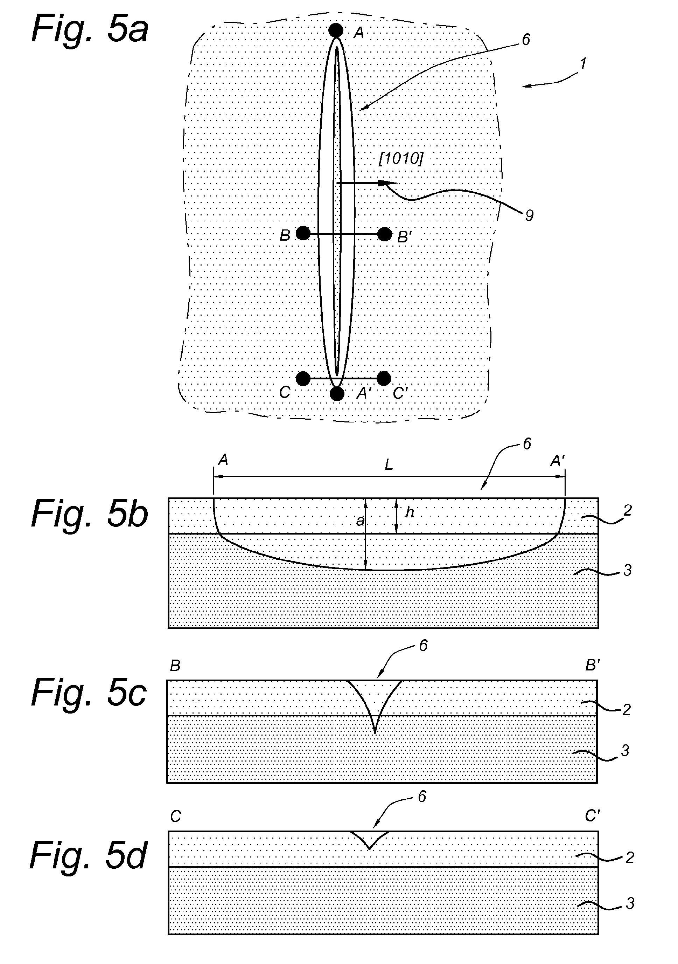

Figure 5a shows a schematic plan-view of a fracture or crack 6 that is oriented in the (1010) plane of a (0001) surface oriented GaN-based layer 2 that is hetero-epitaxially grown on a (111) surface oriented Si layer 3. The fracture 6 propagates from the tensile strained (0001) surface oriented GaN-based layer 2 into the (111) surface oriented Si layer 3. The arrow 9 indicates the [1010] direction of the GaN-based layer 2. Figures 5b-5d show schematic cross-sections of the fracture along the lines A-A', B-B', and C-C', respectively.

Figure 5a schematically shows that the propagation of the crack 6 in the plane of the substrate 1 is arrested at points A and A'. From the schematic cross-sections of the crack 6 shown in figures 5b-5d, the skilled person will appreciate that from a geometrical perspective it follows that the driving force for increasing the crack depth, a, beyond the thickness, $h$, of the GaN-based layer 2, i.e. stress relief in the GaN-based layer, will reduce significantly as the depth, a, exceeds the length, $L$, of the crack 6.

A method to terminate the propagation of cracks is to selectively remove the complete GaN layer. This can be considered to be equivalent to an orthogonal crack. However, this cannot be achieved without creating unacceptable topography in the surface of the semiconductor substrate 1 as the GaN-based layer 2 has a thickness, $h$, that typically lies in a range between 4$\mu$m and 6$\mu$m. Moreover, only partial etching of the GaN-based layer 2 will not halt the crack 6.

In accordance with the present invention, it is possible to limit the lateral extension and the depth, a, of a crack 6 that originates in the GaN-based layer 2 by engineering the propagation of this crack in the lateral direction.

This can be done using a semiconductor substrate 1 having an outside surface and comprising a GaN-based layer and a Si layer. At least one of these layers is provided with a plurality of recesses that are arranged in a plane parallel to said outside surface of the semiconductor substrate 1. These recesses are arranged to divert lateral propagation of a crack 6 in the GaN-based layer 2 into directions that are parallel to at least one of (1010), (1100), and (0110) planes of the GaN-based layer 2 so as to limit the lateral propagation of the crack 6.

By applying the recesses in the semiconductor substrate 1, the crack propagation in the GaN-based layer 2 can be engineered, i.e., the lateral propagation of a crack 6 originating in the GaN-based layer 2 can be limited by diverting the lateral propagation of the crack 6 in directions that are parallel to at least one of the (1010), (1100), and (0110) planes of the GaN-based layer 2.

In this way, the lateral extension of the crack 6 into active regions of semiconductor devices that are fabricated in this semiconductor substrate 1 can be reduced. As a result, the number of devices that are impacted by this crack 6 can be limited. Consequently, this enables a reduction of yield loss and reliability issues.

Limitation of the lateral propagation of the crack 6 that originates in the GaN-based layer 2, also enables to reduce stress relief that results from vertical propagation of this crack 6 into the semiconductor substrate 1. As a result, the depth, a, to which this crack 6 penetrates into the Si layer 3 can at least be limited and possibly even be kept to zero. Consequently, catastrophic fracture of the semiconductor substrate 1 as a result of complete breakage of the Si handle or support layer 3 can at least be limited and possibly even be avoided.

In an embodiment of the semiconductor substrate 1, the recesses of the plurality of recesses comprise trenches 10 having a depth and a length in a length direction, the length direction of the trenches 10 being parallel to at least one of the (1010), (1100), and (0110) planes, which are favourable cleave planes of the GaN-based layer 2.

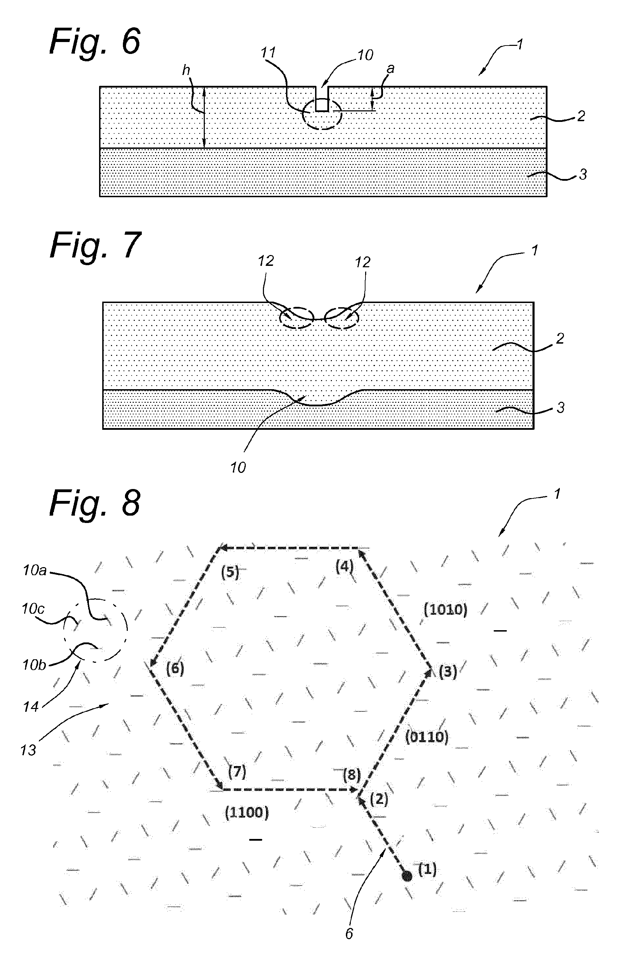

Figure 6 shows a schematic cross-section of an embodiment of the semiconductor substrate 1, in which a trench 10 is provided in a surface of the GaN-based layer 2 facing away from the Si layer 3. In this case, the GaN-based layer has a thickness, $h$, that exceeds the depth, a, of the trench 10 in order to avoid excessive topography of the GaN-based layer 2 which could cause problems during lithography steps needed during device fabrication.

The trench 10 in the GaN-based layer 2 shown in figure 6 causes a weakened region 11 in the surface of the GaN-based layer 2 which enables weakening of the GaN-based layer 2 to crack propagation in the plane of the trench 10.

Therefore, etching trenches 10 in the surface of the GaN-based layer 2 facing away from the Si layer 3, in which the depth, a, of the trenches 10 is smaller than the thickness, $h$, of the GaN-based layer 2, in which the trenches 10 are oriented in the plane of the semiconductor substrate 1, and in which the trenches 10 are parallel to at least one of the (1010), (1100), and (0110) planes of the GaN-based layer 2, could be effective in redirecting cracks 6 with significantly less topography than removing the entire GaN-based layer 2 at the location of trenches 10.

Figure 7 shows a schematic cross-section of an embodiment of the semiconductor substrate 1, wherein a trench 10 is provided in a surface of the Si layer 3 facing towards the GaN-based layer 2. This trench 10 causes topography in the Si layer 3. This topography is transferred to the GaN-based layer 2 upon epitaxial growth of the GaN-based layer on top of this Si layer 3. This topography enhances the tensile stress at the concave regions 12, so encouraging crack propagation parallel to the enhanced stress regions 12.

In an embodiment of the semiconductor substrate 1, as shown in figure 8, the trenches 10 provide a grid 13 having a unit cell 14 that comprises a first trench 10a having a first length in a first length direction parallel to the (1010) plane, a second trench 10b having a second length in a second length direction parallel to the (1100) plane, and a third trench 10c having a third length in a third length direction parallel to the (0110) plane of the GaN-based layer 2.

In an embodiment of the semiconductor substrate 1, the first trench 10a, second trench 10b and third trench 10c are located at edges of a triangular shaped unit cell 14. The first trench 10a, second trench 10b and third trench 10c need not contact one another. The skilled person will appreciate that the unit cell 14 can also have a hexagonal shape.

Figure 8 shows a schematic top view of a layout of a grid 13 having a triangular-shaped unit cell 14. Figure 8 also shows an example of a possible propagation path of a crack 6 (dashed arrow) that nucleated at a first location (1) in the GaN-based layer 2. This crack 6 propagates in its initial propagation direction until it encounters a first trench 10c(2) at a second location (2). This first trench 10c(2) has a first length direction that is parallel to the (0110) plane of the GaN-based layer 2. As a result, the crack 6 is diverted or reoriented by 60° at location (2) and it propagates in the (0110) plane until it encounters a second trench 10a(3) at a third location (3). This second trench 10a(3) has a second length direction that is parallel to the (1010) plane of the GaN-based layer 2. As a result, the crack 6 is diverted or reoriented by 60° at location (3) and it propagates in the (1010) plane until it encounters a third trench 10b(4) at a fourth location (4). This third trench 10b(4) has a third length direction that is parallel to the (1100) plane of the GaN-based layer 2. As a result, the crack 6 is diverted or reoriented by 60° at location (4) and it propagates in the (1100) plane until it encounters a fourth trench 10c(5) at a fifth location (5). This fourth trench 10c(5) has a fourth length direction that is parallel to the (0110) plane of the GaN-based layer 2. As a result, the crack 6 is diverted or reoriented by 60° at location (5) and it propagates in the (0110) plane until it encounters a fifth trench 10a(6) at a sixth location (6). This fifth trench 10a(6) has a fifth length direction that is parallel to the (1010) plane of the GaN-based layer 2. As a result, the crack 6 is diverted or reoriented by 60° at location (6) and it propagates in the (1010) plane until it encounters a sixth trench 10b(7) at a seventh location (7). This sixth trench 10b(7) has a sixth length direction that is parallel to the (1100) plane of the GaN-based layer 2. As a result, the crack 6 is diverted or reoriented by 60° at location (7) and it propagates in the (1100) plane until it intercepts itself at an eighth location (8). Thus, the lateral extent of the crack 6 is limited.

In an embodiment of the semiconductor substrate 1, the grid 13 is offset at an angle from the crystal orientation of the GaN-based layer 2. The skilled person will appreciate that this angle can have any suitable value but must be very well controlled. In the schematic top view of the layout of the grid 13 shown in figure 8, the unit cells 14 comprising the trenches 10a, 10b, and 10c that are parallel to the (1010), (1100), and (0110) planes of the GaN-based layer 2 respectively, are located on a triangular grid that is offset by 10° from the GaN-based crystal orientation.

In an embodiment of the semiconductor substrate 1, the length of the trenches 10 and their positions with respect to each other are configured so as to limit the lateral propagation of a crack 6 in the GaN-based layer 2 between trenches 10 having a different orientation. In this way, no crack 6 can propagate far before encountering a trench 10 of a different orientation, i.e. the length of the trench 10 by which the crack 6 was diverted last and the length of the trench 10 at which the crack arrives next are aligned to different planes out of the (1010), (1100), and (0110) planes of the GaN-based layer 2.

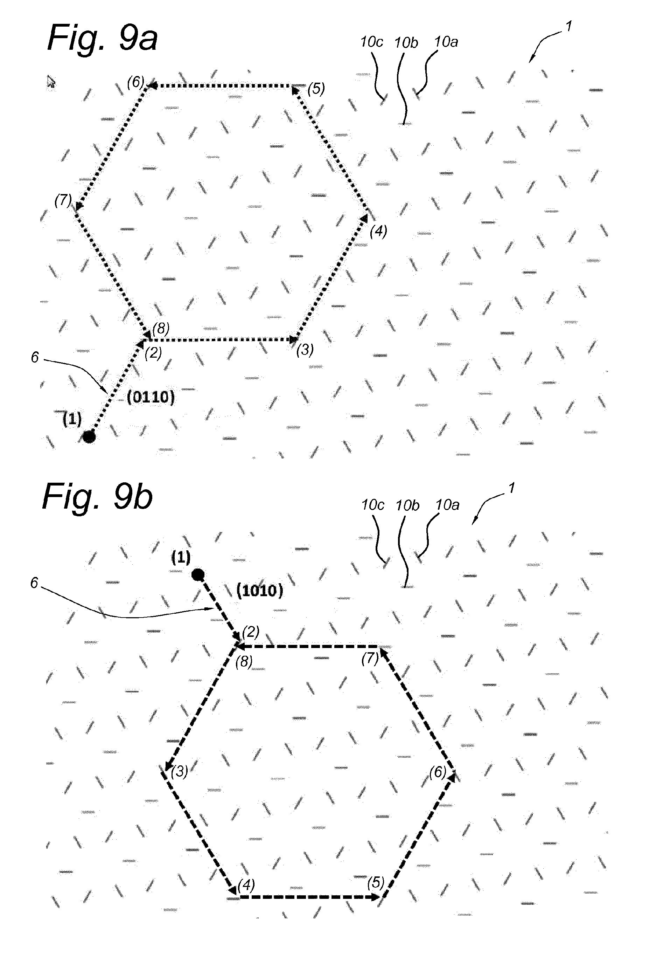

Figure 9a shows a schematic top view of the same layout of the grid 13 as shown in figure 8, in which the crack 6 shown in figure 9a has both a different initial fracture nucleation point (1) than the crack 6 shown in figure 8 and a different initial propagation direction. In the case of figure 9a, the crack 6 has an initial propagation direction that coincides with the (0110) fracture plane of the GaN-based layer 2. Figure 9a illustrates that the layout of the grid 13 according to this embodiment is also effective for limiting the lateral extent of this crack 6. The skilled person will appreciate that it is assumed that diversion or reorientation of the crack 6 is limited to the (1010), (1100), and (0110) fracture planes of the GaN-based layer 2.

Figure 9b also shows a schematic top view of the same layout of the grid 13 as shown in figure 8, wherein the crack 6 shown in figure 9b has both a different initial fracture nucleation point (1) than the cracks 6 shown in figures 8 and 9a, and a different initial propagation direction than these cracks 6. In the case of figure 9b, the crack 6 has an initial propagation direction that coincides with the (1010) fracture plane of the GaN-based layer 2. Figure 9b illustrates that the layout of the grid 13 according to this embodiment is also effective for limiting the lateral extent of this crack 6.

It is noted that it is neither necessary that the diversion or redirection of a crack 6 is 100% successful nor that the diversion or redirection of the crack 6 always occurs in a clockwise (or anti-clockwise) direction in order to achieve the desired limitation of the lateral extension of the crack 6 in the GaN-based layer 2. Any finite probability of diversion or redirection will limit the maximum lateral extent of a crack 6.

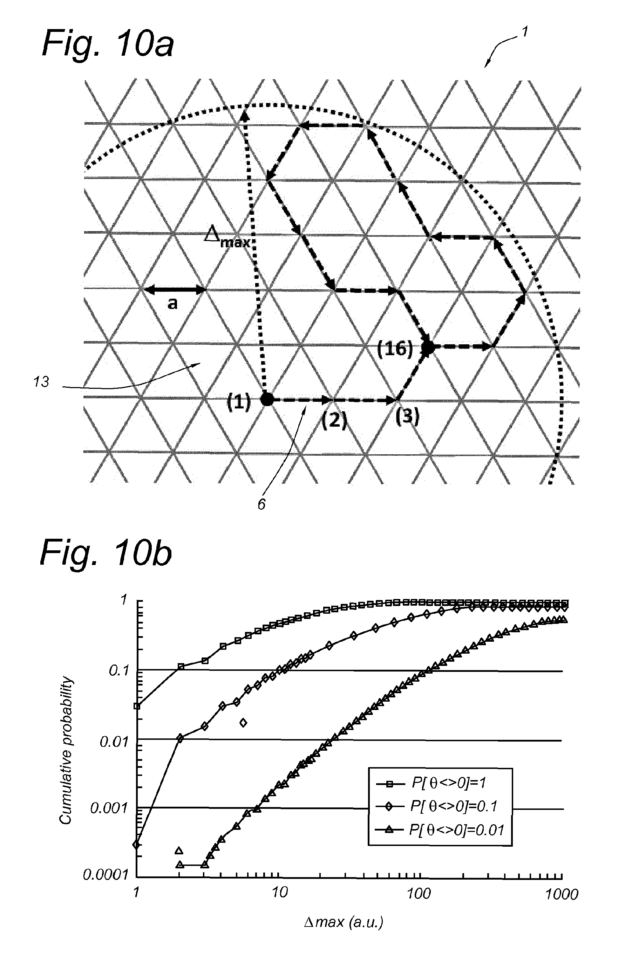

Figure 10a shows a schematic top view of a simulated random walk (dashed arrows) on a triangular lattice 13. Figure 10b shows the results of a Monte Carlo simulation of the maximum lateral extent of a crack ($\Delta$max) following the random walk on the triangular lattice shown in figure 10a. Figure 10b shows the results for various diversion or redirection probabilities (per lattice node). $\Delta$max is in units of length, a. Diversion or redirection of a crack is only permitted through

angles of $\pm 60°$ and walks that do not self-intercept within 1000 steps (length a) are considered to have $\Delta$man>1000.

From figure 10b it can be seen that, even with a diversion or redirection probability P[$\Theta$<>0]=10%, most cracks self-intercept before the crack has extended beyond a distance 60*$a$, whereas for P[$\Theta$<>0]=1%, most cracks self-intercept before a distance 600*a. Conventional lithography and etch capabilities enable trench pitches, a~1$\mu$m. This provides significant scope to optimize the weakness of the trenches, i.e. weak trenches might lead to excessive crack nucleation, whilst still preventing cracks extending beyond a single die where they will impact yield beyond the device where the crack is nucleated, or to lateral extents where fracture of the semiconductor substrate can be driven by stress-relief of the GaN-based layer.

It is possible that locating recesses or trenches within the active regions of devices could degrade their performance. In this case, the trenches could be confined only to at least one of inactive regions within devices and inactive regions separating devices.

In an embodiment of the semiconductor substrate 1, the GaN-based layer 2 comprises at least one of a GaN, aluminium gallium nitride (AlGaN), and indium gallium nitride (InGaN) layer having a (0001) surface orientation. Therefore, in an embodiment of the semiconductor substrate 1, the (0001) surface oriented GaN-based layer 2 may comprise a single (0001) surface oriented GaN layer while in another embodiment the (0001) surface oriented GaN-based layer 2 may comprise a (0001) surface oriented AlGaN layer that is stacked on a (0001) surface oriented GaN layer. The skilled person will appreciate that many different layer stacks can be envisaged falling within the scope of the present invention.

In an embodiment of the semiconductor substrate, the Si layer 3 comprises one of a (111), (100) and (001) surface orientation. The skilled person will appreciate that depending on the nucleation layer and growth conditions it is possible to grow a (0001) surface oriented GaN-based layer 2 on either one of the (111), (100), and (001) surface oriented Si substrates. Especially the (001) surface oriented Si substrate is attractive in view of the possibility to monolithically integrate GaN-based devices with CMOS devices. In the case of a (0001) surface oriented GaN-based layer that is grown on one of a (100) and (001) surface oriented Si substrate, the (0001) plane in the (0001) surface oriented GaN-based layer provides a cleave plane in the GaN-based layer 2 in addition to the (1010), (1100), and (0110) cleave planes that are available in the case of a (0001) surface oriented GaN-based layer that is grown on a (111) surface oriented Si substrate mentioned above.

According to a second aspect of this invention, there is provided a semiconductor device comprising the semiconductor substrate 1. The skilled person will appreciate that this device can be an electronic device, for example any kind of field-effect transistor such as a metal-semiconductor field-effect transistor (MESFET), a high electron mobility transistor (HEMT), or a hetero-junction field-effect transistor (HFET).

In the case of a MESFET, the GaN-based layer 2 comprises a single GaN layer. In the case of a HEMT or an HFET, the GaN-based layer 2 comprises at least a GaN layer and an AlGaN layer. In order to improve the mobility of electrons in the two-dimensional electron gas (2DEG) formed in the GaN layer, it is possible to provide an aluminum nitride (AlN) layer between the GaN layer and the AlGaN layer.

The skilled person will appreciate that the device can also be an optoelectronic device such as a light emitting diode (LED) or a laser diode (LD). In the case of LEDs and LDs in the visible spectrum, the GaN-based layer 2 comprises at least an InGaN layer. In order to improve the optical output efficiency of the LED and the LD, the GaN-based layer comprises at least one quantum well (QW) that comprises an InGaN layer sandwiched between two GaN layers. The GaN-based layer can comprise a multi-quantum well structure (MQW) comprising multiple InGaN layers that are sandwiched between at least GaN layers.

According to a third aspect of this invention, there is provided a method of fabricating a semiconductor substrate 1, the method comprising the steps of:

- providing a GaN-based layer 2 and a Si layer 3 having an outside surface;
- providing at least one of the GaN-based layer 2 and the Si layer 3 with a plurality of recesses 10 that are arranged in a plane parallel to said outside surface of the semiconductor substrate 1, wherein recesses 10 of said plurality of recesses are arranged to divert lateral propagation of a crack 6 in the GaN-based layer 2 into directions parallel to at least one of (1010), (1100), and (0110) planes of the GaN-based layer 2 so as to limit the lateral propagation of the crack 6.

As mentioned above, figure 6 shows a schematic cross-section of an embodiment of the semiconductor substrate 1, wherein a trench 10 is provided in a surface of the GaN-based layer 2 facing away from the Si layer 3. This trench 10 can be made by local etching of the surface of the GaN-based layer 2. The skilled person will appreciate that in the case of a (0001) surface oriented or Ga-face GaN-based layer, only plasma-assisted or dry etching techniques such as reactive ion etching (RIE) and/or inductively coupled plasma etching (ICP) can be used to make the trench 10 as shown in figure 6. Whereas in the case of a (000-1) surface oriented or N-face GaN-based layer that is arranged on top of a Si layer, e.g. via wafer transfer techniques, it is also possible to use wet echting for making the trench 10. However, any other suitable known or yet to be developed technique may be used instead to provide trenches 10.

As mentioned above, figure 7 shows a schematic cross-section of an embodiment of the semiconductor substrate 1, wherein a trench 10 is provided in a surface of the Si layer 3 facing towards the GaN-based layer 2.

This trench 10 can be made by at least one of local etching and local oxidation of the surface of the Si layer 3 facing towards the GaN-based layer 2 that will subsequently be grown on top of the Si layer 3. The skilled person will appreciate that in the case that local oxidation of the surface of the Si layer 3 is used for making the trench or indentation or recess 10, the oxide layer has to be removed before subsequently growing the nucleation or buffer layer and the GaN-based layer 2.

Recesses or trenches 10 might also be formed by combinations of ion implantation and annealing in order to disrupt the crystal structure or to create voids in the crystal as in the "Smart-cut" technique known from a publication that can be assessed by following the following hyperlink: http://en.wikipedia.org/wiki/Smart_Cut. These recesses or trenches 10 should be oriented in the plane of the semiconductor substrate 1 and aligned to at least one of the (1010), (1100), and (0110) planes of the GaN-based layer 2.

Accordingly, as has been described, this invention relates to a semiconductor substrate 1 having an outside surface and having a GaN-based layer 2 and a Si layer 3. At least one of these layers is provided with a plurality of recesses that are oriented in a plane of the semiconductor substrate parallel to an outside surface of the substrate. The recesses are arranged to divert lateral propagation of a crack 6 occurring in the GaN-based layer 2 in directions that are aligned to at least one of (1010), (1100), and (0110) planes of the GaN-based layer 2 having a (0001) surface orientation so as to limit the lateral propagation of the crack 6. This invention also relates to semiconductor devices comprising the semiconductor substrate 1 and methods of fabricating such a semiconductor substrate 1.

In the foregoing description of the drawings, the invention has been described with reference to specific embodiments thereof. It will, however, be evident that various modifications/additions and/or changes/substitutions may be made thereto without departing from the scope of the invention. In addition, many modifications may be made to adapt a particular situation or material to the teachings of the invention without departing from the essential scope thereof. Therefore, it is intended that the invention not be limited to the particular embodiments disclosed, but that the invention will include all embodiments falling within the scope of the appended claims.

In particular, combinations of specific features of various aspects of the invention may be made. An aspect of the invention may be further advantageously enhanced by adding a feature that was described in relation to another aspect of the invention.

It is to be understood that the invention is limited by the annexed claims and its technical equivalents only. In this document and in its claims, the verb "to comprise" and its conjugations are used in their non-limiting sense to mean that items following the word are included, without excluding items not specifically mentioned. In addition, reference to an element by the indefinite article "a" or "an" does not exclude the possibility that more than one of the element is present, unless the context clearly requires that there be one and only one of the elements. The indefinite article "a" or "an" thus usually means "at least one".

**Claims**

1. A semiconductor substrate having an outside surface and comprising a GaN-based layer and a Si layer, at least one of the GaN-based layer and the Si layer being provided with a plurality of recesses that are arranged in a plane parallel to said outside surface of the semiconductor substrate, wherein recesses of said plurality of recesses are arranged to divert lateral propagation of a crack in the GaN-based layer into directions that are parallel to at least one of (1010), (1100), and (0110) planes of the GaN-based layer.

2. The semiconductor substrate according to claim 1, wherein the recesses of the plurality of recesses comprise trenches having a depth and a length in a length direction, the length direction of the trenches being parallel to at least one of the (1010), (1100), and (0110) planes.

3. The semiconductor substrate according to claim 2, wherein the trenches provide a grid having a unit cell that comprises a first trench having a first length direction parallel to the (1010) plane, a second trench having a second length direction parallel to the (1100) plane, and a third trench having a third length direction parallel to the (0110) plane.

4. The semiconductor substrate according to claim 3, wherein the unit cell has a triangular shape.

5. The semiconductor substrate according to claim 3 or 4, wherein the grid is offset at an angle from a crystal orientation of the GaN-based layer, said crystal orientation being one of (0001) and (000-1).

6. The semiconductor substrate according to any one of the claims 2 to 5, wherein the length of the trenches and their positions with respect to each other are configured so as to limit the lateral propagation of the crack in the GaN-based layer in-between trenches having different orientations.

7. The semiconductor substrate according to any one of the claims 2 to 6, wherein the trenches are provided in a surface of the GaN-based layer facing away from the Si layer.

8. The semiconductor substrate according to claim 7, wherein the GaN-based layer has a thickness that exceeds the depth of the trenches.

9. The semiconductor substrate according to claim 2, wherein the trenches are provided in a surface of the Si layer facing towards the GaN-based layer.

10. The semiconductor substrate according to any one of the previous claims, wherein the GaN-based layer comprises at least one of a GaN, AlGaN, and InGaN layer having a (0001) surface orientation.

11. The semiconductor substrate according to any one of the previous claims, wherein the Si layer comprises one of a (111), (100), and (001) surface orientation.

12. A semiconductor device comprising the semiconductor substrate according to any one of the previous claims.

13. A method of fabricating a semiconductor substrate according to any one of the claims 1 to 10, the method comprising the steps of:

   - providing a GaN-based layer and a Si layer having an outside surface;
   - providing at least one of the GaN-based layer and the Si layer with a plurality of recesses that are arranged in a plane parallel to said outside surface of the semiconductor substrate, wherein recesses of said plurality of recesses are arranged to divert lateral propagation of a crack in the GaN-based layer into directions that are parallel to at least one of (1010), (1100), and (0110) planes of the GaN-based layer.

14. The method according to claim 13, wherein the plurality of recesses are provided to the GaN-based layer by local etching of a surface of the GaN-based layer facing away from the Si layer.

15. The method according to claim 13, wherein the plurality of recesses are provided by at least one of local etching and local oxidation of a surface of the Si layer facing towards the GaN-based layer.

## Fig. 1

## Fig. 2

# Fig. 3

# Fig. 4

Fig. 5a

*A*

6

1

[1010]

9

*B* *B'*

*C* *A'* *C'*

Fig. 5b

*A* L 6 *A'*

2

*a* *h*

3

Fig. 5c

*B* 6 *B'*

2

3

Fig. 5d

*C* 6 *C'*

2

3

## Fig. 6

## Fig. 7

## Fig. 8

## Fig. 9a

## Fig. 9b

## Fig. 10a

## Fig. 10b

Europäisches
Patentamt

European
Patent Office

Office européen
des brevets

**EUROPEAN SEARCH REPORT**

Application Number

EP 14 17 6156

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | ZAMIR S ET AL: "Thermal microcrack distribution control in GaN layers on Si substrates by lateral confined epitaxy", APPLIED PHYSICS LETTERS, AMERICAN INSTITUTE OF PHYSICS, US, vol. 78, no. 3, 15 January 2001 (2001-01-15), pages 288-290, XP012028398, ISSN: 0003-6951, DOI: 10.1063/1.1338968 * the whole document * | 1-15 | INV. H01L21/02 |
| X | KROST A ET AL: "GAN-BASED DEVICES ON SI", PHYSICA STATUS SOLIDI (A). APPLIED RESEARCH, BERLIN, DE, vol. 194, no. 2, 1 December 2002 (2002-12-01), pages 361-375, XP008036694, ISSN: 0031-8965, DOI: 10.1002/1521-396X(200212)194:2<361::AID-PSSA361>3.0.CO;2-R * Patterned Substrates; page 364 * | 1-15 | |
| X | US 2013/161643 A1 (CROWDER MARK ALBERT [US] ET AL) 27 June 2013 (2013-06-27) * claims 1, 14; figure 12A * | 1-15 | TECHNICAL FIELDS SEARCHED (IPC) H01L |

The present search report has been drawn up for all claims

| Place of search | Date of completion of the search | Examiner |
|---|---|---|
| Munich | 5 September 2014 | Kenevey, Kester |

CATEGORY OF CITED DOCUMENTS

X : particularly relevant if taken alone
Y : particularly relevant if combined with another
　　document of the same category
A : technological background
O : non-written disclosure
P : intermediate document

T : theory or principle underlying the invention
E : earlier patent document, but published on, or
　　after the filing date
D : document cited in the application
L : document cited for other reasons

& : member of the same patent family, corresponding
　　document

EPO FORM 1503 03.82 (P04C01)

**ANNEX TO THE EUROPEAN SEARCH REPORT
ON EUROPEAN PATENT APPLICATION NO.**                    EP 14 17 6156

This annex lists the patent family members relating to the patent documents cited in the above-mentioned European search report.
The members are as contained in the European Patent Office EDP file on
The European Patent Office is in no way liable for these particulars which are merely given for the purpose of information.

05-09-2014

| Patent document cited in search report | Publication date | Patent family member(s) | Publication date |
|---|---|---|---|
| US 2013161643 A1 | 27-06-2013 | NONE | |

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **A. A. GRIFFITH.** The phenomena of rupture and flow in solids. *Philosophical Transactions of the Royal Society of London,* 1921, vol. A 221, 163-198
- **D.M. FOLLSTAEDT ; J. HAN ; P. PROVENCIO ; J. G. FLEMING.** Microstructure of GaN Grown on (111) Si by MOCVD. *Proceedings of the Materials Research Society,* 1998, vol. 537

- **A. A. GRIFFITH.** The phenomena of rupture and flow in solids. *Philosophical Transactions of the Royal Society of London,* 1921, vol. A 221, 163-198, http://en.wikipedia.org/wiki/Fracture_mechanics#cite_note-1
- **G. IRWIN.** Analysis of stresses and strains near the end of a crack traversing a plate. *Journal of Applied Mechanics,* 1957, vol. 24, 361-364
- **J.W. HUTCHINSON ; Z. SUO.** Mixed mode cracking in multilayers. *Advances in Applied Mechanics,* 1992, 29